# EUROPÄISCHE PATENTANMELDUNG

(11) **EP 1 361 517 A2**
(43) Veröffentlichungstag der Anmeldung: **12.11.2003**
(21) Anmeldenummer: 03008165.7
(22) Anmeldetag: 21.12.1997
(51) Int. Cl.: G06F 12/08

(54) **Datenverarbeitungsverfahren und Vorrichtung hierfür**

(30) Priorität: 20.12.1996 DE 19654595
(62) Teilanmeldung aus: 97953672.9
(71) Anmelder: Pact Informationstechnologie GmbH, 80939 Munchen (DE)
(72) Erfinder: Vorbach, Martin, 80689 München (DE); Münch, Robert, 76185 Karlsruhe (DE)
(74) Vertreter: Pietruk, Claus Peter, Dipl.-Phys.

(57) **Zusammenfassung**

Die Erfindung betrifft ein Verwaltungsmittel zur Verwaltung der Zugriffe auf externe Anschlüsse eines Bausteines mit mehrdimensional angeordneter, programmierbarer Zellstruktur. Hierbei ist vorgesehen, daß zwischen zumindest einem der internen Busse und einem der externen Busse ein Cache-Mittel vorgesehen ist, um Daten, die über die externen Busse angefordert werden sollen, cachen zu können und nur für solche Daten eine Aufschaltung auf die externen Busse vorzusehen, die nicht gecached oder cachebar sind.

## Beschreibung

### 1. Hintergrund der Erfindung

### 1.1. Stand der Technik

### 1.1.1 ... in DFP-basierenden Systemen

In DFPs gemäß DE 44 16 881 A1 werden die Leitungen jeder Kantenzelle, das ist eine Zelle, die sich am Rand eines Zellarrays befindet und oftmals direkt Kontakt mit den Anschlüssen des Bausteines haben kann, über die Anschlüsse des Bausteines herausgeführt. Dabei haben die Leitungen keine spezielle Funktion, vielmehr übernehmen sie die Funktion, die in den Kantenzellen beschrieben ist. Werden mehrere DFPs miteinander vernetzt, so werden alle Anschlüsse zu einer Matrix miteinander verbunden. Der Baustein besitzt zur internen Datenübertragung einzelne Leitungen, die die Daten bitweise übertragen. Eine Bündelung der Leitungen zu Bussystemen bleibt dem Anwender Überlassen. Die Ansteuerung der externen Bausteine, unabhängig ob es sich um Speicher, Peripherie oder weitere DFPs handelt muß ebenfalls vom Anwender implementiert werden.

### 1.1.2 ... in Systemen mit zwei- oder mehrdimensionalen programmierbaren Zellstrukturen (FPGAs, DPGAs)

In Systemen mit zwei- oder mehrdimensionalen programmierbaren Zellstrukturen (FPGAs, DPGAs) wird eine bestimmte Teilmenge von internen Bussystemen und Leitungen der Kantenzellen über die Anschlüsse des Bausteines herausgeführt. Dabei haben die Leitungen keine spezielle Funktion, vielmehr übernehmen sie die Funktion, die in den Kantenzellen beschrieben ist. Werden mehrere FPGAs/DPGAs miteinander vernetzt, so übernehmen die Anschlüsse die Funktion, die hardware- oder softwareseitig implementiert wurde. Wie aus US 5,570,040 bekannt werden einzelne Leitungen von dem Zellarray zu fest implementierten IO-Treibern, bzw. von den IO-Treibern zu dem Zellarray geführt. Die Leitungen sind nicht gebündelt sonderen arbeiten bitweise. In den IO-Treibern sind keine dedizierten Strukturen zu Generierung von Adressen für Speicher oder Peripherie, oder zur Unterstützung von Kommunikationsprotokollen zwischen gleichartigen Bausteinen aus der Gattung FPGA oder DPGA vorgesehen.

### 1.2 Probleme

### 1.2.1 ... in DFP-basierenden Systemen

Der Verdrahtungsaufwand für die Peripherie oder Vernetzung von DFPs ist sehr hoch. Gleichzeitig hat der Programmierer dafür zu sorgen, daß die entsprechenden Funktionen in die Zellen des/der DFPs integriert werden. Zum Anschluß eines Speichers muß eine Speicherverwaltung in den Baustein integriert werden. Zum Anschluß von Peripherie muß diese unterstatzt werden, ebenso wie die Kaskadierung von DFPs entsprechend berücksichtigt werden muß. Der Aufwand ist verhältnismäßig hoch, gleichzeitig. geht Fläche auf dem Baustein für die jeweiligen Implementierungen verloren.

### 1.2.2 ... in Systemen mit zwei- oder mehrdimensionalen programmierbaren Zellstrukturen (FPGAs, DPGAs)

Oben beschriebenes gilt ebenfalls für FPGAs und DPGAs, insbesondere, wenn diese zur Implementierung von Algorithmen eingesetzt werden und als numerische (Co)Prozessoren arbeiten.

### 1.3 Verbesserung durch die Erfindung, Aufgabe

Der Verdrahtungsaufwand, insbesondere die Anzahl der Bausteinanschlüsse, wird erheblich reduziert. Ein einheitliches Bussystem arbeitet ohne besondere Rücksichtnahme durch den Programmierer. Die Steuerung des Bussystems ist fest implementiert. Ohne besondere Meßnanmen kann an das Bussystem Speicher, sowie Peripherie angeschlossen werden. Ebenfalls können Bausteine mit Hilfe das Bussystems kaskadiert werden.

### 2. Beschreibung der Erfindung

### 2.1 Übersicht über die Erfindung, Abstrakt

Die Erfindung beschreibt ein allgemeines Bussystem, das eine Vielzahl bausteininterner Leitungen zusammenfaßt und als Bündel an die Anschlüsse herausführt. Die Steuerung des Bussystems ist dabei vordefiniert und bedarf keines Einflusses durch den Programmierer. An das Bussystem lassen sich beliebig Speicher, Peripherie oder weitere Bausteine zur Kaskadierung anschließen. Die Einzelheiten und besondere Ausgestaltungen, sowie Merkmale des erfindungsgemäßen Bussystems sind Gegenstand der Patentansprüche.

### 2.2 Detailbeschreibung der Erfindung

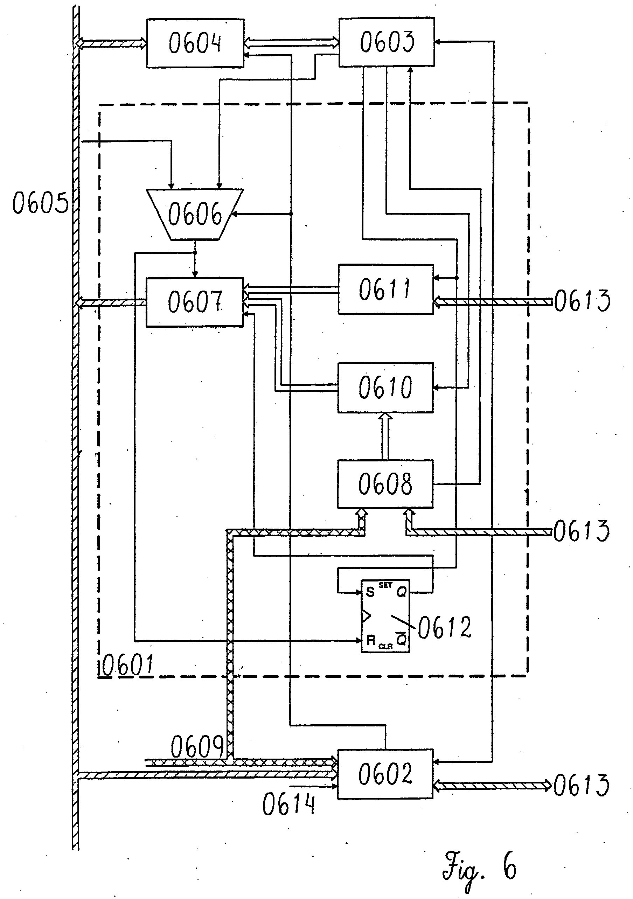

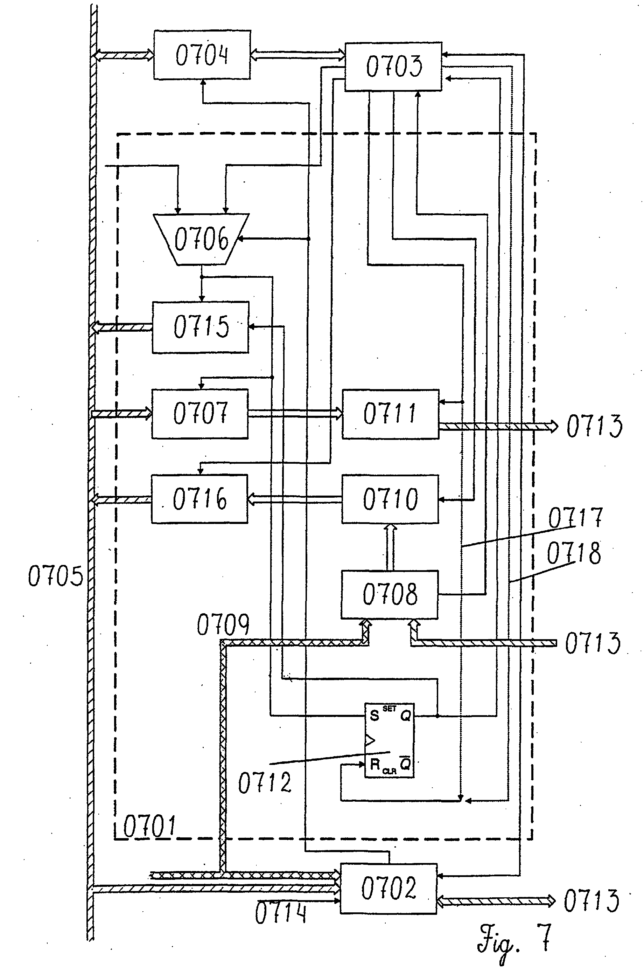

Die nachfolgende Beschreibung umfaßt mehrere Strukturen, die wie bei DFPs, FPGAs, DPGAs, o.ä. üblich von einer Ladelogik aus gesteuert und konfiguriert werden. Dabei können Teile der Ladelogik auf dem Baustein integriert sein. Alternativ besteht die Möglichkeit (Fig. 6/7) die Strukturen durch den Baustein selbst direkt dynamisch umzukonfigurieren oder zu steuern. Dabei können die Strukturen fest auf dem Baustein implementiert sein, oder erst durch Konfiguration und möglicherweise Zusammenschluß mehrere Logikzellen, das sind konfigurierbare Zellen, die einfache logische ode arithmetische Aufgaben gemäß ihrer Konfiguration erfüllen (vgl. DFP, FPGA, DPGA), entstehen.

### 2.2.1 Bündelung interner Leitungen

Um sinnvolle Busstrukturen zu erhalten, wird eine Mehrzahl interner Leitungen zu Bussen (I-BUSn; n gibt die Nummer des Busses an) zusammengefaßt. Dabei kann es sich bei den Leitungen um interne Bussysteme oder um Leitungen der Rantenzellen handeln. Die einzelnen Busse werden für schreibzugriffe auf den externen Bus (E-BUS) über taktsynchrone Latche oder Register (I-GATE-REG) auf Tore geführt, die als Schalter zum E-BUS arbeiten. Eine derartige Einheit wird Ausgabezelle (OUTPUT-CELL) genannt. Der Zugriff auf den E-BUS-geschieht derart, daß die einzelnen Latche über die Tore auf den gemeinsamen E-BUS geschaltet werden. Dabei ist immer nur ein Tor geöffnet. Jeder I-BUSn besitzt eine eindeutige Kennummer (n: z.B. I-BUS1, I-BUS976, ...).
Für Lesezugriffe wird der hereinführende E-BUS in taktsynchrone Latche oder Register (E-GATE-REG) zwischengespeichert und dann über die Tore an die I-BUSn verteilt. Eine derartige Einheit wird Eingabezelle (INPUT-CELL) genannt. Der Abgriff vom E-BUS geschieht dabei derart, daß ein E-BUS-Transfer in ein oder mehrere E-GATE-REG geschrieben wird. Die E-GATE-REG können dann entweder einzeln oder gemeinsam auf ihre internen Bussysteme freigeschaltet werden.
Dabei können die Schreib-/Lesezugriffe in beliebiger Reihenfolge ablaufen. Es ist unter Umständen sinnvoll die internen Busse I-BUSn in zwei Gruppen zu unterteilen, die schreibenden Ausgabebusse IO-BUSn und die lesenden Eingabebusse II-BUSn.

### 2.2.2 Adressgenerierung

Für die meisten Zugriffe auf externe Bausteine ist es notwendig Adressen zur Auswahl eines Bausteines oder Teilen eines Bausteines zu generieren. Dabei können die Adressen fest sein, das heißt sie ändern sich nicht (dies ist vor allem bei Peripherieadressen der Fall) oder die Adressen verändern sich bei jedem Zugriff um (meist) feste Werte (dies ist vor allem bei Speicheradresssen der Fall). Zur Generierung der Adressen existieren programmierbare Zähler für die Lesezugriffe und programmierbare Zähler für die Schreibzugriffe. Die Zähler werden durch die Ladelogik, das ist die Einheit, die die, auf einer Zellstruktur basierenden konfigurierbaren Bausteine (DFPs, FPGAs, DPGAs o.ä.) konfiguriert, auf einen Grundwert eingestellt. Bei jedem Zugriff auf das Tor zählt der Zähler je nach Einsteilung um einen von der Ladelogik festgelegten Wert nach oben oder unten. Ebenfalls kann jeder Zähler als Register verwendet werden, das bedeutet, bei einem Zugriff wird nicht gezählt, der im Zähler eingestellte Wert ist statisch. Jedem Bustransfer wird als Adresse der Wert des zum Tor gehörenden Zählers zugeordnet. Die Einstellung des Zählers geschieht über ein Einstellungsregister (MODE-PLUREG), das von der Ladelogik beschrieben wird.

### 2.2.3 Masken und Zustände

Jedem Tor ist eine Anzahl Bits im später beschriebenen MODE-PLUREG zugeordnet, die angibt, ob das Tor aktiv ist oder von der Steuerung übergangen wird, also ausmaskiert ist (MASKE). Das bedeutet, das Tor wird beim Durchlaufen aller Tore zum Aufschalten auf das jeweilige Bussystem übergangen. Folgende Masken-Einträge sind denkbar:
- INPUT-/OUTPUT-CELL immer übergehen
- INPUT-/OUTPUT-CELL nur beim Schreiben übergehen
- INPUT-/OUTPUT-CELL nur beim Lesen übergehen, wenn der E-BUS-MAS\-TER nicht auf die INPUT-/OUTPUT-CELL zugegriffen hat
- INPUT-/OUTPUT-CELL niemals übergehen

Jedem Tor ist ein Zustandsregister, das als RS-Flipflop ausgestaltet sein kann, zugeordnet. Dieses Register zeigt an, ob Daten in das zum Tor gehörenden Register geschrieben wurden.

### 2.2.4 Das MODE-PLUREG

Das MODE-PLUREG kann von der Ladelogik beschrieben und gelesen werden. Es dient zur Einstellung des Bussystems.

### Ein möglicher Aufbau des MODE-PLUREG aus Sicht der Ladelogik

| Bit l..m | Bit k..l | Bit 2 k | Bit 1 | Bit 0 |
|---|---|---|---|---|
| Maske | Vordefinierter Wert | Schrittbreite | 0=additiv zählen 1=subtraktiv zählen | 0=Register 1=Zähler |
| maskieren | Einstellungen für Adressgenerator | | | |

### 2.2.5 Beschreibung der INPUT-CELL

Es wird unterschieden, ob Daten vom E-BUS in den Baustein gelangen (die dafür notwendige Einheit wird INPUT-CELL genannt) oder ob Daten aus dem Baustein auf den E-BUS gelangen (die dafür notwendige Einheit wird OUTPUT-CELL genannt).

Eine INPUT-CELL kann wie folgt ausgestaltet sein: Ein Latch (I-GATE-REG), das entweder vom externen E-BUS-MASTER oder der bausteineigenen Zustandsmaschine gesteuert wird, dient zur Zwischenspeicherung der Daten, die vom E-BUS erhalten werden. Dabei ist das Taktsignal des Latches an ein (z.B.) RS-Flipflop (SET-REG) geführt, das den Zugriff auf das I-GATE-REG festhält. Hinter dem I-GATE-REG befindet sich ein Tor (I-GATE), das von der Zustandsmaschine gesteuert wird.Ober das I-SATE gelangen die Daten aus dem I-GATE-REG auf den I(I)-BUSn.

Des weiteren befindet sich ein programmierbarer auf/abwärts-Zähler in der INPUT-CELL. Er kann nach jedem aktiven Lesezugriff auf den E-BUS durch die Zustandsmaschine gesteuert, um einen einstellbaren Wert hoch- oder herunterzählen. Ebenfalls kann er als einfaches Register dienen. Dieser Zähler generiert die Adressen für Buszuqriffe, in denen der Baustein E-BUS MASTER ist. Die Adressen werden durch ein Tor (ADR-GATE) auf den E-BUS geführt.
Das ADR-REG wird von der Zustandsmaschine gesteuert.

Ober ein weiteres Tor (STATE-GATE) kann der E-BUS-MASTER den Zustand des SET-REG abfragen. Jede INPUT-CELL besitzt ein MODE-PLUREG, in dem die Ladelogik den Zähler konfiguriert und die INPUT-CELL aus- oder einschaltet (maskiert).

### 2.2.6 Beschreibung der OUTPUT-CELL

Eine OUTPUT-CELL kann wie folgt ausgestaltet sein: Ein Latch (E-GATE-REG), das von der bausteineigenen Zustandsmaschine gesteuert wird, dient zur Zwischenspeicherung der Daten, die vom I-BUS erhalten werden.

Des weiteren befindet sich ein programmierbarer auf/abwärts-Zähler in der OUT-PUT-CELL. Dabei ist das Taktsignal des Latches an ein (z.B.) RS-Flipflop (SET-REG) geführt, das den Zugriff auf das E-GATE-REG festhält. Er kann nach jedem aktiven Lesezugriff auf den E-BUS durch die Zustandsmaschine gesteuert, um einen einstellbaren Wert hoch- oder herunterzählen. Ebenfalls kann er als einfaches Register dienen. Dieser Zähler generiert die Adressen für Buszugriffe, in denen der Baustein E-BUS-MASTER ist.

Die Daten des E-GATE-REG, die Adressen und der Zustand des SET-REG werden über ein Tor (E-GATE), das entweder vom externen E-BUS-MASTER oder der bausteineigenen Zustandsmaschine gesteuert wird, auf den geführt. Jede OUTPUT-CELL besitzt ein MODE-PLUREG, in dem die Ladelogik den Zähler konfiguriert und die OUTPUT-CELL aus- oder einschaltet (maskiert).

### 2.2.7 Steuerung des Bussystems

Den einzelnen Toren, Adressgeneratoren und Masken ist eine Steuerung übergeordnet. Diese besteht aus einer einfachen Zustandsmaschine nach dem Stand der Technik. Dabei werden zwei Betriebsarten unterschieden:
1. Eine Aktive, in der die Zustandsmaschine den internen Bus (I-BUS) und den externen Bus (E-BUS) steuert. Diese Betriebsart wird E-BUS-MASTER genannt, da die Zustandsmaschine die Kontrolle über den E-BUS besitzt.
2. Eine Passive, in der die Zustandsmaschine nur den internen Bus (I-BUS) steuert. Der E-BUS wird von einem anderen externen Baustein kontrolliert. Die Zustandsmaschine reagiert in dieser Betriebsart auf die Anforderungen des externen E-BUS-MASTERS. Diese Betriebsart wird E-BUS-SLAVE genannt.

Die Steuerung verwaltet das E-BUS Protokoll. Dabei ist der Ablauf unterschiedlich, je nachdem, ob die Steuerung als E-BUS-MASTER oder E-BUS-SLAVE arbeitet. Ein Busprotokoll wird in dieser Schrift nicht beschrieben, da eine Vielzahl von Protokollen nach dem Stand der Technik implementiert werden können.

### 2.2.8 E-BUS-MASTER und E-BUS-SLAVE, das EB-REG

Zur Verwaltung des Datenverkehrs auf dem E-BUS existiert das E-BUS-Steuerregister (EB-REG). Es ist in Reihe mit den Toren geschaltet und kann vom E-BUS aus adressiert und angesprochen werden. Über folgende Einträge könnte der Datenaustausch geregelt werden:
- I-WRITE: zeigt: an, daß der I-BUS komplett in die INPUT-/OUTPUT- CELLs geschrieben ist
- I-READ :: zeigt an, daß der I-BUS die INPUT-/OUTPUT-CELLs komplett gelegen hat
- E-WRITE:: zeigt an, daß der E-BUS komplett in die INPUT-/OUTPUT- CELLs geschrieben ist
- E-READ :: zeigt an, daß der E-BUS die INPUT-/OUTPUT-CELLS komplett gelesen hat

Das EB-REG ist immer nur auf der Seite des E-BUS-SLAVE aktiv und der E-BUS-MASTER greift lesend und schreibend darauf zu.
- Alle I-...-Einträge werden vom E-BUS-SLAVE geschrieben und vom E-BUS-MASTER gelesen.
- Alle E-...-Einträge werden vom E-BUS-MASTER geschrieben und vom E-BUS-SLAVE gelesen.

Ein E-BUS-SLAVE kann die Kontrolle über den E-BOS fordern, in dem er das Bit REQ-MASTER in seinem EB-REG setzt. Erkennt der E-BUS-MASTER das Bit REQ-MASTER, so muß er seine Buskontrolle so bald wie möglich abgeben. Dies geschieht, in dem er das Bit MASTER im EB-REG eines E-BUS-SLAVE setzt. Er schaltet daraufhin sofort die E-BUS passiv. Der alte E-BUS-SLAVE wird zum neuen E-BUS-MASTER und der alte E-BUS-MASTER wird zum neuen E-BUS-SLAVE. Der neue E-BUS-MASTER übernimmt die Steuerung des E-BUS. Zur Erkennung des ersten E-BUS-MASTERs nach einer Rücksetzung (RESET) des Systems, existiert ein Anschluß an jedem Baustein, der durch die voreingestellte Polarität angibt, ob der Baustein nach einem RESET E-BUS-MASTER oder E-BUS SLAVE ist. Der Eintrag MASTER im EB-REG kann auch von der Ladelogik gesetzt und zurückgesetzt werden. Dabei hat die Ladelogik darauf zu achten, daß keinerlei Buskollisionen am EB-BUS entstehen oder laufende Transfers abgebrochen werden.

### 2.2.9 E-BUS-MASTER schreibt Daten in E-BUS-SLAVE

Folgendermaßen kann der E-BUS-MASTER Daten in den E-BUS-SLAVE schreiben:
⇒ Die Datenübertragung beginnt damit, daß die Zustandsmaschine des E-BUS-MASTERs eine OUTPUT-CELL auswählt, die nicht ausmaskiert ist.
⇒ Im I-GATE-REG sind, je nach Ausführung der Zustandsmaschine, bereits Daten gespeichert oder die Daten werden jetzt gespeichert.
⇒ Das Tor wird aktiviert.
   → Die gültige Leseadresse wird auf den Bus übertragen.
   → Die Daten gelangen auf den E-BUS und werden in das E-GATE-REG des E-BUS-SLAVE gespeichert.
⇒ Dadurch wird das SET-REG im E-BUS-SLAVE aktiviert.
⇒ Das Tor im E-BUS-MASTER wird deaktiviert.
⇒ Der Adresszähler generiert die Adresse für den nächsten Zugriff.
⇒ Der Transfer ist für den E-BUS-MASTER beendet.

Auf der Seite des E-BUS-SLAVE existieren zwei Ausgestaltungsmöglichkeiten die Baten vom Bus in den Baustein zu transferieren:
1. Das Daten-Tor ist immer offen und die Daten gelangen direkt vom E-GATE-REG auf den I-BUSn.
2. Die Zustandsmaschine erkennt, daß SET-REG aktiviert ist und aktiviert das Tor, dadurch kann SET-REG zurückgesetzt werden.

Der E-BUS-MASTER kann dem E-BUS-SLAVE mitteilen, wann ein kompletter Buszyklus beendet ist. (Ein Buszyklus ist als das Übertragen mehrerer Datenworte an unterschiedliche E-GATE-REG definiert, wobei jedes E-GATE-REG genau ein Mal angesprochen werden darf.)
⇒ Dazu setzt der E-BUS-MASTER am Ende eines Buszyklus das Bit E-WRITE im EB-REG des E-BUS-SLAVE.
⇒ Der E-BUS-SLAVE kann darauf reagieren, in dem er die INPUT-CELLs abfragt.
⇒ Hat er alle INPUT-CELLs abgearbeitet, setzt er das Bit I-READ in seinem EB-REG.
⇒ Dabei setzt er E-WRITE und sämtliche SET-REG der INPUT-CELLs zurück.
⇒ Der E-BUS-MASTER kann I-READ abfragen und nach dessen Aktivierung einen neuen Buszyklus beginnen.
⇒ I-READ wird durch Schreiben von E-WRITE oder den ersten Bustransfer zurückgesetzt.

Der E-BUS-SLAVE kann anhand des Zustandes des EB-REG oder der einzelnen SET-REG der INPUT-CELLs auswerten, ob die INPUT-CELLs neu gelesen werden können/müssen.

### 2.2.10 E-BUS-MASTER liest Daten von E-BUS-SLAVE

Aus der Sicht des E-BUS-MASTERs existieren zwei grundlegende Methoden Daten vom E-BUS-SLAVE zu lesen:
1. Verfahren, in dem die E-BUS-Daten direkt auf den I-BUS gelangen:
   ⇒ Die Datenübertragung beginnt damit, daß die Zustandsmaschine des E-BUS-MASTERs eine INPUT-CELL auswählt, die nicht ausmaskiert ist.
   ⇒ Das I-GATE und das ADR-GATE werden aktiviert.
      → Die gültige Leseadresse wird auf den Bus übertragen.
   ⇒ Das I-GATE-REG ist transparent, d.h. es läßt die Daten auf den I-BUSn durch.
   ⇒ Das Tor im E-BUS-MASTER wird deaktiviert.
   ⇒ Der Adresszähler generiert die Adresse für den nächsten Zugriff.
   ⇒ Der Transfer ist für den E-BUS-MASTER beendet.
2. Verfahren, in dem die E-BUS-Daten im I-GATE-REG zwischengespeichert werden:
   ⇒ Die Datenübertragung beginnt damit, daß die Zustandsmaschine des E-BUS-MASTERs eine INPUT-CELL auswählt, die nicht ausmaskiert ist.
   ⇒ Das I-GATE und das ADR-GATE werden aktiviert.
      → Die gültige Leseadresse wird auf den Bus übertragen.
   ⇒ Das T-GATE-REG speichert die Daten.
   ⇒ Das Tor im E-BUS-MASTER wird deaktiviert.
   ⇒ Der Adresszähler generiert die Adresse für den nächsten Zugriff.
   ⇒ Der E-BUS-Transfer ist für den E-BUS-MASTER beendet.
   ⇒ Alle am E-BUS-Transfer beteiligten INPUT-CELLs, dies kann anhand der Masken in den MODE-PLUREG oder dem Zustand der SET-REG festgestellt werden, werden durchlaufen und die Daten auf den jeweiligen I-BUS übertragen.

Für den E-BUS-SLAVE sieht der Zugriff wie folgt aus:
⇒ Durch den E-BUS wird das Tor aktiviert.
⇒ Die Daten und der Zustand des möglicherweise vorhandenen SET-REG gelangen auf den E-BUS.
⇒ Das Tor wird deaktiviert.

Der E-BUS-MASTER kann dem E-BUS-SLAVE mitteilen, wann ein kompletter Buszyklus beendet ist.
⇒Dazu setzt der E-BUS-MASTER am Ende. eines Buszyklus das Bit E-READ im EB-REG des E-BUS-SLAVE.
⇒Der E-BUS-SLAVE kann darauf reagieren, in dem er die OUTPUT-CELLs neu beschreibt.
⇒Hat er alle OUTPUT-CELLs abgearbeitet, setzt er das Bit I-WRITE in seinem EB-REG.
⇒Dabei setzt er E-READ und sämtliche SET-REG der OUTPUT-CELLs zurück.
⇒Der E-BUS-MASTER kann I-WRITE abfragen und nach dessen Aktivierung einen neuen Buszyklus beginnen.
⇒ I-WRITE wird durch Schreiben von E-READ oder den ersten Bustransfer zurückgesetzt.

Der E-BUS-SLAVE kann anhand des Zustandes des EB-REG oder der einzelnen SET-REG der OUTPUT-CELLs auswerten, ob die OUTPUT-CELLs neu beschrieben werden können/müssen.

### 2.2.11 Anschluß von Speicher, Peripherie und Kaskadierung

Außer der Kaskadierung von gleichen Bausteinen (DFPs, FPGAs, DPGAs) kann an das beschriebene Bussystem Speicher und Peripherie als untergeordnete SLAVE-Baustein (SLAVE) angeschlossen werden. Dabei kann Speicher und Peripherie, sowie weitere Bausteine (DFPs, FPGAs) gemischt werden. Jeder angeschlossene SLAVE wertet die Adressen auf dem Bus aus und erkennt selbständig ob er angesprochen ist. In diesen Betriebsarten ist der Baustein, der den Speicher oder die Peripherie, also die SLAVE-Bausteine anspricht, der Bus-MASTER (MASTER), d.h. der Baustein steuert den Bus und den Datentransfer. Die Ausnahme bilden intelligente Peripheriebausteine, wie z.B. SCSI-Kontroller, die selbständig Transfers initieren und durchführen können und daher E-BUS-MASTER sind.

### 2.2.12 Zusammenfassung

Durch das beschriebene Verfahren, lassen sich Bussysteme einfach und leistungsfähig an DFPs und FPGAs anschließen. Dabei können über die Bussysteme sowohl Speicher und Peripherie, als auch weitere Bausteine o.g. Gattung verbunden werden.

Das Bussystem muß nicht ausschließlich in den DFPs, FPGAs und DPGAs implementiert sein. Selbstverstandlich ist ein Mischbetrieb dieses Bussystemes mit den herkömmlichen Anschlußstrukturen der Bausteine möglich. Damit können die Vorteile der jeweiligen Technik optimal genutzt werden.

Es sind weitere Ablaufverfahren für das beschriebene Bussystem denkbar. Diese werden jedoch nicht beschrieben, da es sich um freie Ausgestaltungsmöglichkeiten handelt, die vom hier aufzuzeigenden Grundprinzip unabhängig sind.

### 3 Kurzbeschreibung der Diagramme

- Figur 1 :: Zeichnung eines Basisbausteines als FPGA Typ A
- Figur 2 :: Zeichnung eines Basisbausteines als FPGA Typ B
- Figur 3 :: Zeichnung eines Basisbausteines als DFP
- Figur 4 :: Leitungsbundelung in FPGAs
- Figur 5 :: Leitungsbündelung in DFPs
- Figur 6 :: Eine OUTPUT-CELL
- Figur 7 :: Eine INPUT-CELL
- Figur 8 :: Die Adressgenerierung
- Figur 9 :: Komplettes Bussystem mit Steuerung
- Figur 10 :: Anschluß von Speicher und Peripherie
- Figur 11 :: Das EB-REG
- Figur 12 :: Ausführungsbeispiel
- Figur 13 :: Ausführungsbeispiel 2
- Figur 14 :: Bus-IO des zweiten Ausführungsbeispiels
- Figur 15a:: Adress-Generator des zweiten Ausführungsbeispiels
- Figur 15b:: Alternativer Adress-Generator der eine End-of-Data Kennung erzeugt
- Figur 15c:: Funktionsablauf beim Adress-Generator mit End-of-Data Kennung
- Figur 16 :: Zusammenspiel zweier Segmente bei der indirekten Adressierung.
- Figur 17 :: Die State-Machine für die indirekte Adressierung

### 4 Detailbeschreibung der Diagramme

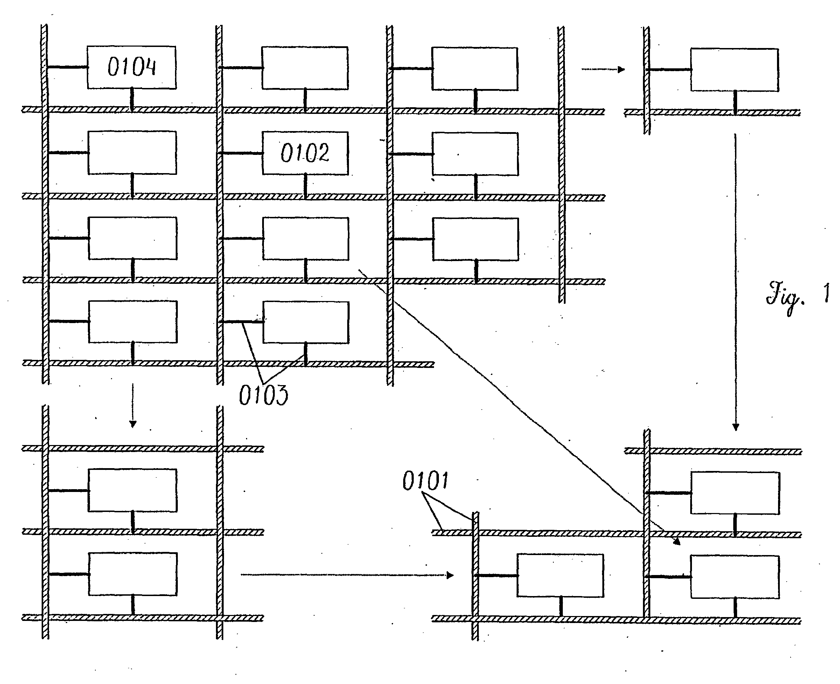

Figur 1 zeigt einen FPGA nach dem Stand der Technik. 0101 stellt die internen Bussysteme dar, 0102 beinhaltet eine oder mehrer FPGA-Zelle(n). 0103 sind Teilbusse, die eine Teilmenge von 0101 darstellen und über Schalter (Crossbars) mit 0101 verbunden sind. 0103 kann auch interne Daten von 0102 verwalten, die nicht auf 0101 geschaltet werden. Die FPGA-Zellen sind in einem 2-dimensionalen Array angeordnet.
0104 stellt eine Kantenzelle dar, die am Rand des Arrays sitzt und sich somit in nächster Nähe zu den Anschlüssen am Rand des Bausteins befindet.

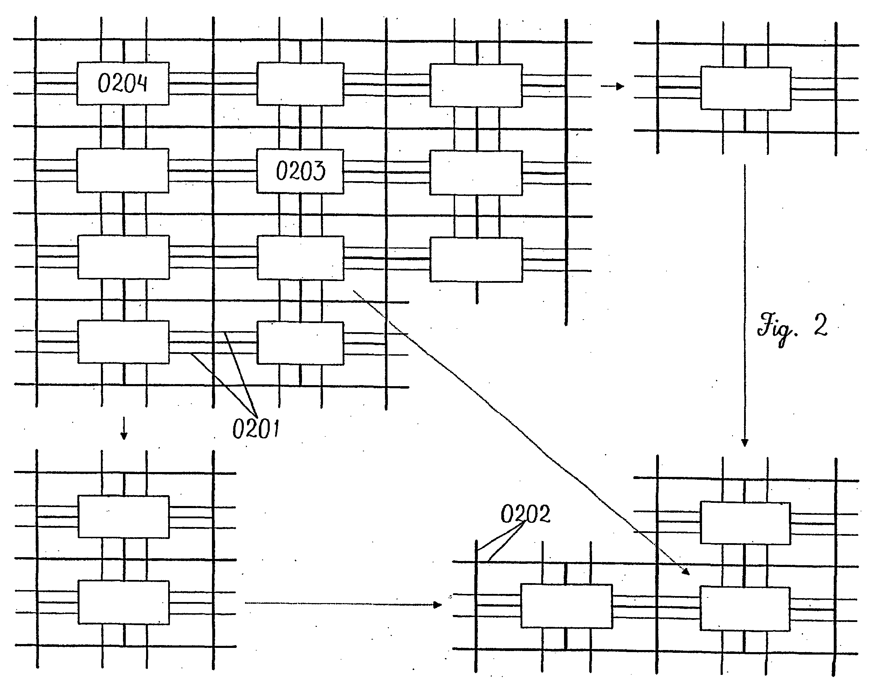

Figur 2 zeigt einen weiteren FPGA nach dem Stand der Technik.
Diese Ausführungsmöglichkeit arbeitet nicht mit Bussystemen wie 0101 sondern hauptsächlich mit Next-Neighbour-Verbindungen (0201), das sind direkte Verbindungen von einer FPGA-Zelle (0203) zu ihrer Nachbarzelle. Es können dennoch globale Bussysteme (0202) existieren, diese sind jedoch nicht sehr breit.Die FPGA-Zellen oder eine Gruppe von FPGA-Zellen besitzen eine Verbindung zu 0202. Die FPGA-Zellen sind in einem 2-dimensionalen Array angeordnet. 0204 stellt eine Kantenzelle dar, die am Rand des Arrays sitzt und sich somit in nächster Nähe zu den Anschlüssen am Rand des Bausteins befindet.

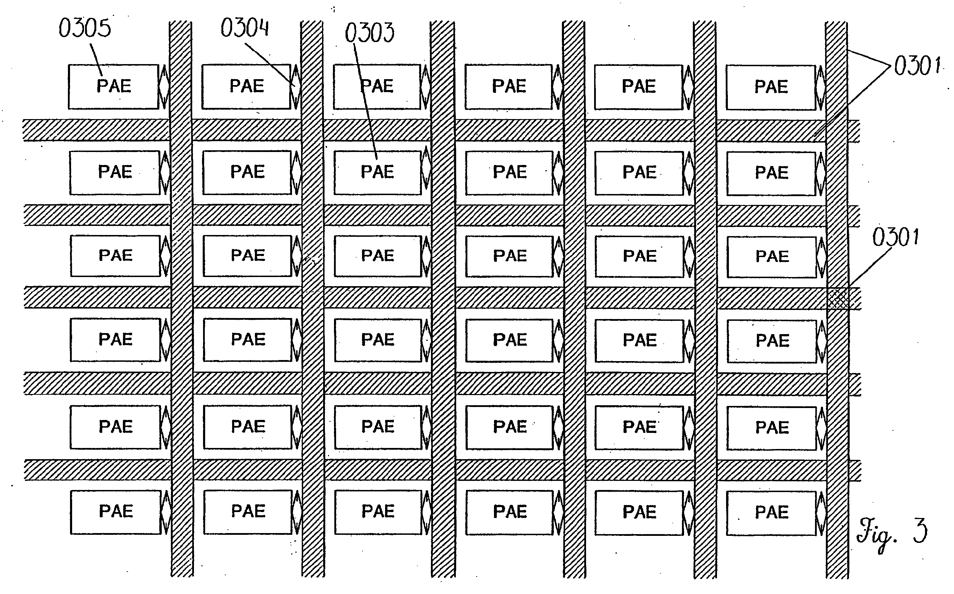

Figur 3 zeigt einen DFP nach DE 196 51 075.9. Dabei sind die PAE-Zellen (0303) über ein Businterface (0304) auf die Bussysteme (0301) geschaltet. Die Bussysteme 0301 können über einen Busschalter (0302) miteinander verschaltet werden. Die PAE-Zellen sind in einem 2-dimensionalen Array angeordnet. 0305 stellt eine Kantenzelle dar, die am Rand des Arrays sitzt und sich somit in nächster Nähe zu den Anschlüssen am Rand des Bausteins befindet.

Figur 4a zeigt eine FPGA-Kante nach Figur 1. Außerhalb der Kantenzellen (0401) ist eine Mehrzahl von INPUT-/OUTPUT-CELLs (0402) angeordnet, die zu mehreren oder einzeln die internen Bussysteme (0403) mit dem E-BUS (0404) verbinden. Dabei ist die Menge der INPUT-/OUTPUT-CELLs von ihrer eigenen Breite im Verhältnis zur Breite der internen Bussysteme abhängig. 0405 stellt ein EB-REG dar. 0406 stellt eine Zustandsmaschine dar. Von der Zustandsmaschine geht zum EB-REG und jeder einzelnen INPUT-/OUTPUT-CELL ein Bussystem (0407), über das die Zustandsmaschine die INPUT-/OUTPUT-CELLs steuert. Dabei können mehrere 0405 und 0406 existieren, indem je eine Menge an 0402 zu Gruppen zusammengefaßt werden und von je einer 0405 und 0406 verwaltet werden.

Figur 4b zeigt eine FPGA-Kante nach Figur 2. Außerhalb der Kantenzellen (0411) ist eine Mehrzahl von INPUT-/OUTPUT-CELLs (0412) angeordnet, die zu mehreren oder einzeln die internen Bussysteme (0413) und die direkten Verbindungen der Kantenzellen (0418) mit dem E-BUS (0414) verbinden. Dabei ist die Menge der INPUT-/OUTPUT-CELLs von ihrer eigenen Breite im Verhältnis zur Breite der internen Bussysteme (0413) und der Menge der direkten Verbindungen (0418) abhängig. 0415 stellt ein EB-REG dar. 0416 stellt eine Zustandsmaschine dar. Von der Züstandsmaschine geht zum EB-REG und jeder einzelnen INPUT-/OUTPUT-CELL ein Bussystem (0417), über das die Zustandsmaschine die IMPUT-/OUTPUT-CELLs steuert.
Dabei können mehrere 0415 und 0416 existieren, indem je eine Menge an 0412 zu Gruppen zusammengefaßt werden und von je einer 0415 und 0416 verwaltet werden.

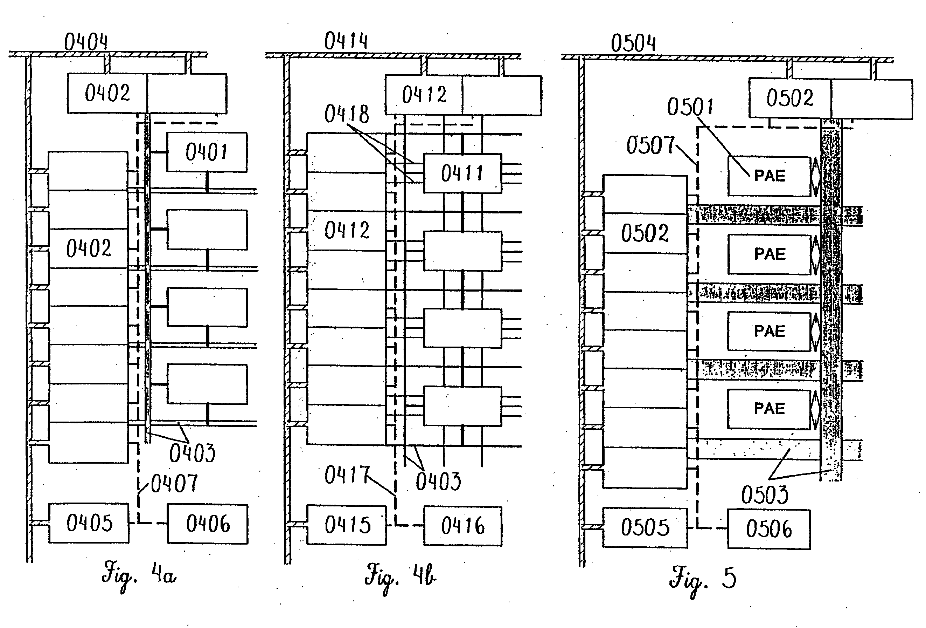

Figur 5 zeigt eine DFP-Kante nach Figur 3. Außerhalb der Kantenzellen (0501) ist eine Mehrzahl von INPUT-/OUTPUT-CELLs (0502) angeordnet, die zu mehreren oder einzeln die internen Bussysteme (0503) mit dem E-BUS (0504) verbinden. Dabei ist die Menge der INPUT-/OUTPUT-CELLs von ihrer eigenen Breite im Verhältnis zur Breite der internen Bussysteme (0503) abhängig. 0505 stellt ein EB-REG dar. 0506 stellt eine Zustandsmaschine dar. Von der Zustandsmaschine geht zum EB-REG und jeder einzelnen INPUT-/OUTPUT-CELL ein Bussystem (0507), über das die Zustandsmaschine die INPUT-/OUTPUT-CELLs steuert. Dabei können mehrere 0505 und 0506 existieren, indem je eine Menge an 0412 zu Gruppen zusammengefaßt werden und von je einer 0505 und 0506 verwaltet werden.

Figur 6 zeigt eine OUTPUT-CELL 0601. Außerhalb 0601 befindet sich das EB-REG (0602) und die Zustandsmaschine (0603), sowie ein Tor (0604), das die Zustandsmaschine auf den E-BUS (0605) schaltet, sofern sie E-BUS-MASTER ist. Auf das EB-REG kann über den E-BUS (0605), den I-BUS (0613) und den Ladelogikbus (0609) zugegriffen werden.
Weiterhin kann bei einem Rücksetzen des Bausteins (Reset) über einen externen Anschluß (0614), der aus dem Baustein herausgeführt ist, das MASTER-Bit gesetzt werden. Die Zustandsmaschine (0603) greift schreibend und lesend auf 0602 zu. In der OUTPUT-CELL befindet sich ein Multiplexer (0606), der die Steuerung des E-GATE (0607) entweder dem E-BUS-MASTER oder der Zustandsmaschine (0603) zuordnet.
Das MODE-PLUREG (0608) wird über den Ladelogikbus (0609) oder den I-BUS (0613) eingestellt und konfiguriert den Adresszähler (0610), sowie die Zustandsmaschine (z.B. ausmaskieren der OUTPUT-CELL). Werden Daten des I-BOS (0613) in das I-GATE-REG (0611) gespeichert, wird der Zugriff im SET-REG (0612) vermerkt. Der Zustand von 0612 ist über 0607 am E-BUS abfragbar. Ein lesender Zugriff (das E-GATE 0607 ist aktiviert) setzt 0612 zurück. Die von 0610 generierten Adressen und die Daten von 0611 werden über das Tor 0607 auf den E-BUS übertragen. Es besteht die Möglichkeit die OUTPUT-CELL statt über die Ladelogik über den Baustein (DFP, FPGA, DPGA, o.ä.) selbst dynamisch umzukonfigurieren und zu steuern. Hierzu dient der der 1-BUS-Anschluß an das EB-REG (0602) und das MODE-PLUREG (0608).

Figur 7 zeigt eine INPUT-CELL 0701. Außerhalb 0701 befindet sich das EB-REG (0702) und die Zustandsmaschine (0703), sowie ein Tor (MASTER-GATE) (0704), das die Zustandsmaschine auf den E-BUS (0705) schaltet, sofern sie E-BUS-MASTER ist. Auf das EB-REG kann ilher den E-BUS (0705), den I-BUS (0713) und den Ladelogikbus (0709) zugegriffen werden. Weiterhin kann bei einem Rücksetzen des Bausteins (Reset) über einen externen Anschluß (0714), der aus dem Baustein herausgeführt ist, das MASTER-Bit gesetzt werden. Die Zustandsmaschine (0703) greift schreibend und lesend auf 0702 zu. In der INPUT-CELL befindet sich ein Multiplexer (0706), der die Steuerung des E-GATE-REG (0707) entweder dem E-BUS-MASTER oder der Zustandsmaschine (0703) zuordnet. Das MODE-PLUREG (0708) wird über den Ladelogikbus (0709) oder den I-BUS (0713) eingestellt und konfiguriert den Adresszähler (0710), sowie die Zustandsmaschine (z.B. ausmaskieren der INPUT-CELL). Werden Daten des E-BUS (0705) in das E-GATE-REG (0707) gespeichert, wird der Zugriff im SET-REG (0712) vermerkt.
Der Zustand von 0712 ist über ein Tor (0715), dessen Steuerung dieselbe wie beim Latch (0707) ist, am E-BUS abfragbar. Ein lesender Zugriff, das E-GATE 0711 ist aktiviert und die Daten gelangen auf den I-BUS (0713) setzt 0712 über 0717 zurück. Alternativ kann 0712 über die Zustandsmaschine (0703) zurückgesetzt werden (0718).
Die von 0710 generierten Adressen werden über das Tor (ADR-GATE) 0716 auf den E-BUS übertragen, 0716 wird von der Zustandsmaschine (0703) aktiviert, wenn diese E-BUS-MASTER ist. Es besteht die Möglichkeit die INPUT-CELL statt über die Ladelogik über den Baustein (DFP, FPGA, DPGA, o.ä.) selbst dynamisch umzukonfigurieren und zu steuern. Hierzu dient der der I-BUS-Anschluß an das EB-REG (0702) und das MODE-PLUREG (0708).

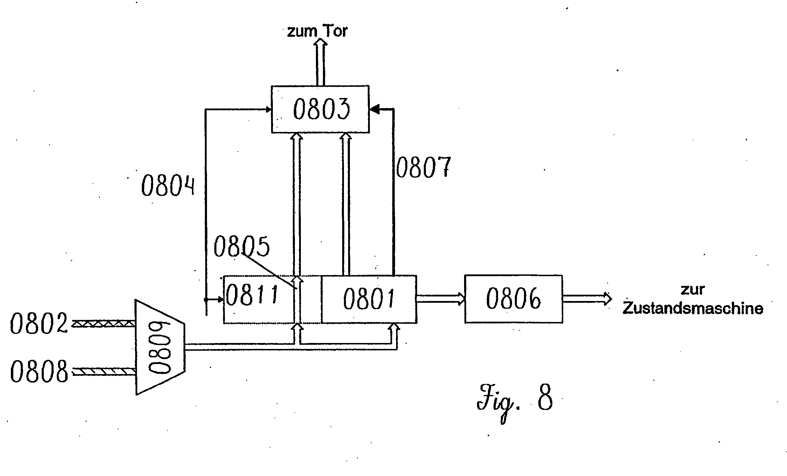

Figur 8 zeigt das MODE-PLUREG (0801) einer INPUT- oder OUTPUT-CELL, das über den Ladelogikbus (0802) von der Ladelogik oder über einen I-BUS (0808) beschrieben wird.
Das jeweilige Bussystem wird über den Multiplexer (0809) ausgewählt, dabei ist die Steuerung des Multiplexers nicht eingezeichnet, da eine gewöhnliche Dekodierlogik verwendet werden kann. Die Zählereinstellungen, wie Schrittbreite Zahlrichtung und Freischaltung des Zählers werden direkt (0807) an den Zähler (0803) geleitet. Die Grundadresse kann entweder über einen Load (0804) direkt in den Zähler geschrieben (0805) werden, oder in einem Zusatz (0811) zu 0801 zwischengespeichert werden. Die für die Zustandsmaschine relevanten Einträge in 0801 gelangen über ein Tor (0806), das von der Zustandsmaschine für die jeweilig aktivierte INPUT- oder OUTPUT-CELL geöffnet wird, zur Zustandsmaschine.

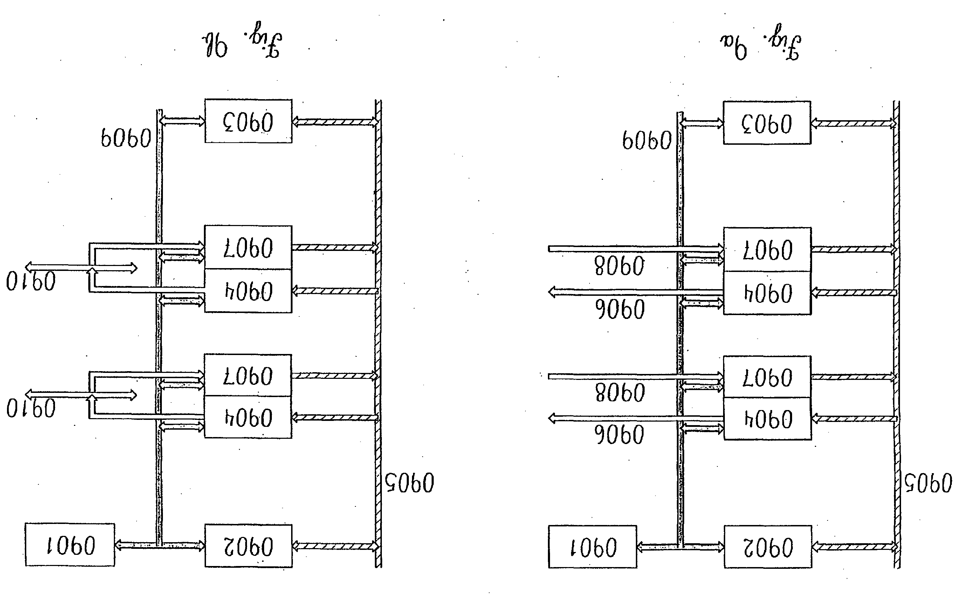

Figur 9a zeigt eine Businterfaceschaltung mit Zustandsmaschine (0901), MASTER-GATE (0902) und EB-REG (0903). Die INPUT-CELLs (0904) transferieren Daten vom E-BUS (0905) auf den II-BUS (0906). Die OUTPUT-CELLs (0907) transferieren Daten vom IO-BUS (0908) auf den E-BUS (0905). Über den Steuerbus (0909) sind sämtliche Baugruppen miteinander verbunden.

Figur 9b zeigt eine Businterfaceschaltung mit Zustandsmaschine. (0901), MASTER-GATE (0902) und EB-REG (0903). Die INPOT-CELLs (0904) transferieren Daten vom E-BUS (0905) auf den bidirektionalen I-BUS (0910). Die OUTPUT-CELLs (0907) transferieren Daten vom bidirektionalen I-BUS (0910) auf den E-BUS (0905). Über den Steuerbus (0909) sind sämtliche Baugruppen miteinander verbunden. Es sind auch Interfaceschaltungen denkbar, die beide Möglichkeiten (Fig. 9a und 9b) gemischt verwenden.

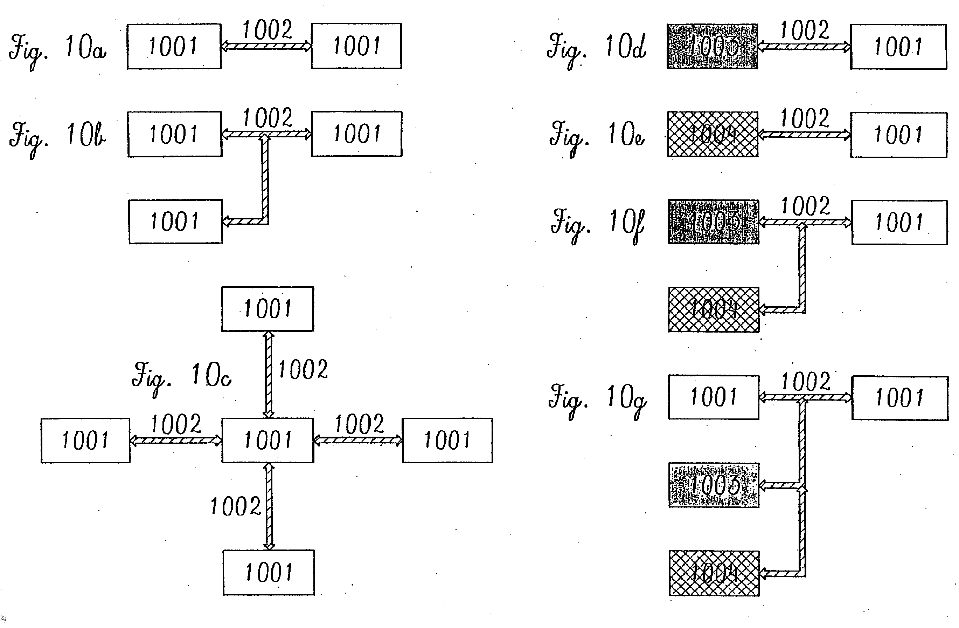

Figur 10a zeigt zwei Bausteine (DFPs, FPGAs, DPGAs, o.ä.) (1001) über den E-BUS (1002) miteinander vernetzt.

Figur 10b zeigt die Vernetzung einer Mehrzahl von Bausteinen (DFPs, FPGAs, DPGAs, o.ä.) (1001) über den E-BUS (1002).

Figur 10c zeigt die Vernetzung einer Mehrzahl von Bausteinen (DFPs, FPGAs, DPGAs, o.ä.) (1001) über den E-Bus (1002). Die Vernetzung kann zu einer Matrix ausgebaut werden. Ein Baustein (1001) kann auch eine Mehrzahl von Bussystemen (1002) verwalten.

Figur 10d zeigt die Vernetzung eines Bausteins (DFPs, FPGAs, DPGAs, o.ä.) (1001) mit einen Speicherbaustein oder einer Speicherbank (1003) über den E-BUS (1002).

Figur 10e zeigt die Vernetzung eines Bausteins (DFPs, FPGAs, DPGAs, o.ä.) (1001) mit einem Peripheriebaustein oder einer Peripheriegruppe (1004) über den E-BUS (1002).

Figur 10f zeigt die Vernetzung eines Bausteins (DFPs, FPGAs, DPGAs, o.ä.) (1001) mit einem Speicherbaustein oder einer Speicherbank (1003) und mit einem Peripheriebaustein oder einer Peripheriegruppe (1004) über den E-BUS (1002).

Figur 10g zeigt die Vernetzung eines Bausteins (DFPs, FPGAs, DPGAs, o.ä.) (1001) mit einem Speicherbaustein oder einer Speicherbank (1003) und mit einem Peripheriebaustein oder einer Peripheriegruppe (1004) und einem weiteren Baustein (DFPs, FPGAs, DPGAs, o.ä.) (1001) über den E-BUS (1002).

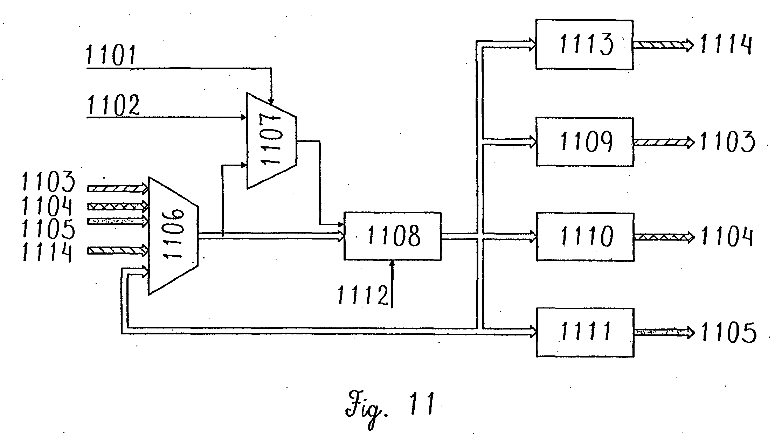

Figur 11 zeigt den Aufbau des EB-REG. Die Bussysteme E-BUS (1103); Ladelogikbus (1104), über welchen die Ladelogik Zugriff auf das EB-REG hat und der lokale interne Bus zwischen den INPUT-/OUTPUT-CELLs, der Zustandsmaschine und dem EB-REG (1105, vgl. 0407, 0417, 0517), sowie möglicherweise ein I-BUS (1114) werden auf einen Multiplexer (1106) geführt. Der Multiplexer (1106) wählt entweder einen der Busse oder die Rückkopplung auf das Register (1108) aus und schaltet die Daten zum Eingang des Registers (1108) durch. Das MASTER-Bit wird getrennt über den Multiplexer (1107) zum Register (1108) geführt. Der Multiplexer wird über das RESET-Signal (1101) (Rücksetzen order Initialisieren des Bausteines) qesteuert. Liegt ein RESET an, so schaltet der Multiplexer (1107) das Signal eines externen Chipanschlusses (1102) auf den Eingang des Registers (1108) durch, andernfalls wird der Ausgang des Multiplexers (1106) auf den Eingang des Registers (1108) durchgeschaltet. Dadurch kann MASTER vorbelegt werden. Das Register (1108) wird über den Systemtakt (1112) getaktet. Der Inhalt des Registers (1108) wird über ein Tor (1109, 1110, 1111, 1113) auf das jeweils lesend zugreifenden Bussystem (1103, 1104, 1105, 1114) geschaltet.
Die Steuerung der Tore (1109, 1110, 1111, 1113), sowie des Multiplexers (1106) ist nicht eingezeichnet, da eine gewöhnliche Dekodierlogik verwendet werden kann.

### 5 Ausführungsbeispiele

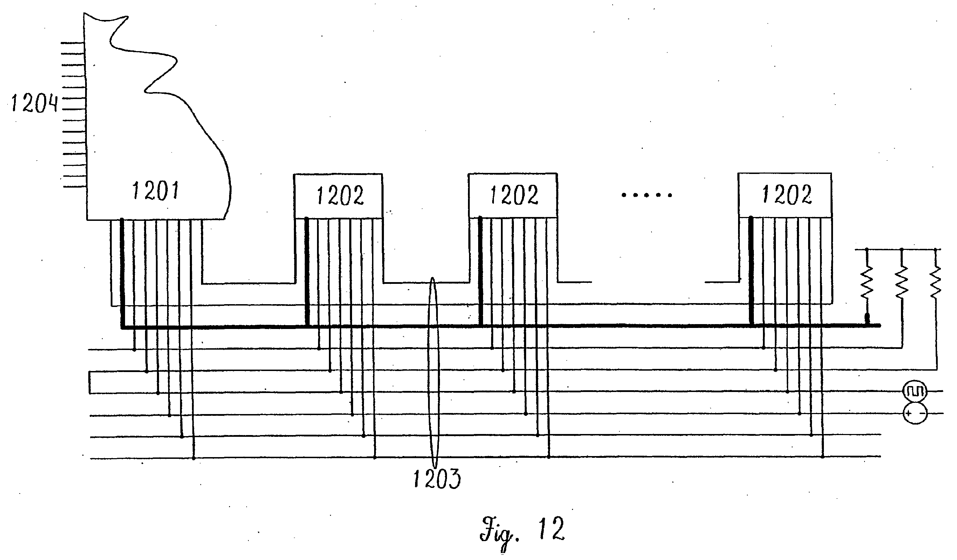

Figur 12 zeigt ein Beispiel, bei dem das Standardbussystems RAMBUS (1203) eingesetzt wird. Ein Baustein (DFPs, FPGAs, DPGAs, o.ä.) (1201) ist über das Bussystem (1203) mit weiteren Baugruppen (Speicher, Peripherie, weitere DFPs, FPGAs, DPGAs, o.ä.) (1202) verbunden. Der Baustein (1201) kann unabhängig vom Bussystem (1203) weitere Anschlußleitungen (1204), z.B wie nach dem Stand der Technik üblich, zum Anschluß beliebiger Schaltkreise aufweisen.

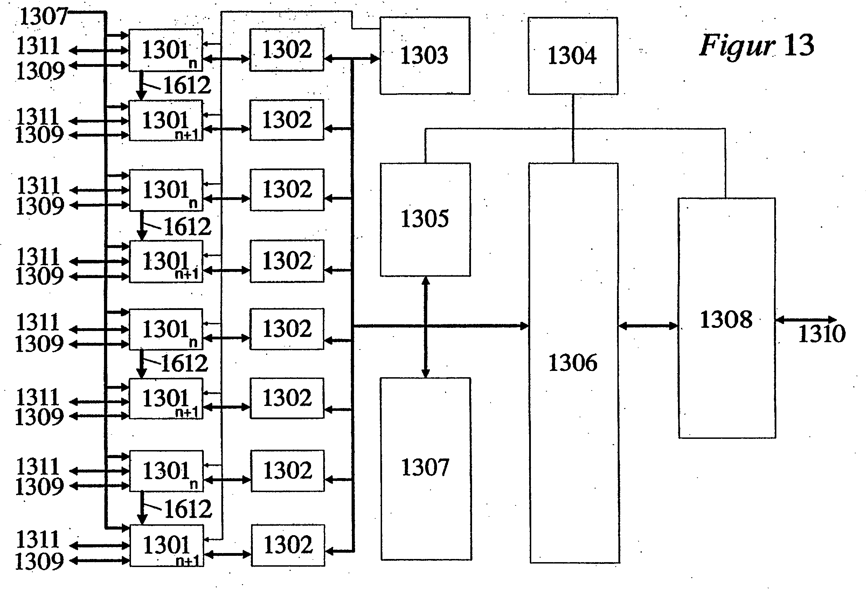

Figur 13 zeigt ein Implementierungsbeispiel für ein IO- und Speicherbussystem. 1310 bildet den Rambus, der das Rambus-Interface (1308) mit dem Rambus-Speicher verbindet. Das Rambusinterface ist mit einem Cache-Ram (1306) verbunden. Dem Cache-Ram (1306) ist ein Tag-Ram (1307), sowie ein Cache-Controller (1305) zugeordnet. Mit Hilfe des-Cache-Controllers und des Tag-Ram wird geprüft ob angeforderte Daten im Cache-Speicher vorhanden sind oder ob sie aus dem externen Rambus-Speicher geladen werden müssen. Gesteuert werden das Cache-Ram, der Cache Controller und das Rambus-Interface von einer State-Machine (1304). Das cache wird nach dem Stand der Technik implementiert.
Der Arbiter (1303) regelt den Zugriff der einzelnen Bussegmente auf das Cache-Ram und somit auch auf den externen Speicher. Bei diesem Implementierungsbeispiel kann auf acht Bussegmente zugegriffen werden. Jede Verbindung zu einem Bussegment (1309) besitzt eine Bus-IO (1301) und einen Address-Generator (1302). Außerdem ist jede Bus-IO noch mit dem Ladelogikbus (1307) verbunden, sowie mit einem internen Test-Bus (1311). Jede n-te Bus-IO ist mit der (n+1)-ten Bus-IO verbunden, wobei für n gilt n ={1,3,5,...}. Durch diese Vebindung können Daten, die von dem n-ten Adress-Generator aus dem Speicher angefordert wurden, vom (n+1)-ten Segment als Adresse für einen Speicherzugriff benutzt werden Damit ist eine indirekte Adressierung des Speichers möglich. Der Wert des Zählers (1509) des Segmentes n zeigt auf eine Speicherstelle im Ram. Die Daten aus dieser Speicherstelle werden zum Segment (n+1) übertragen und dienen dort als Base-Adresse zur Adressierung des Speichers.

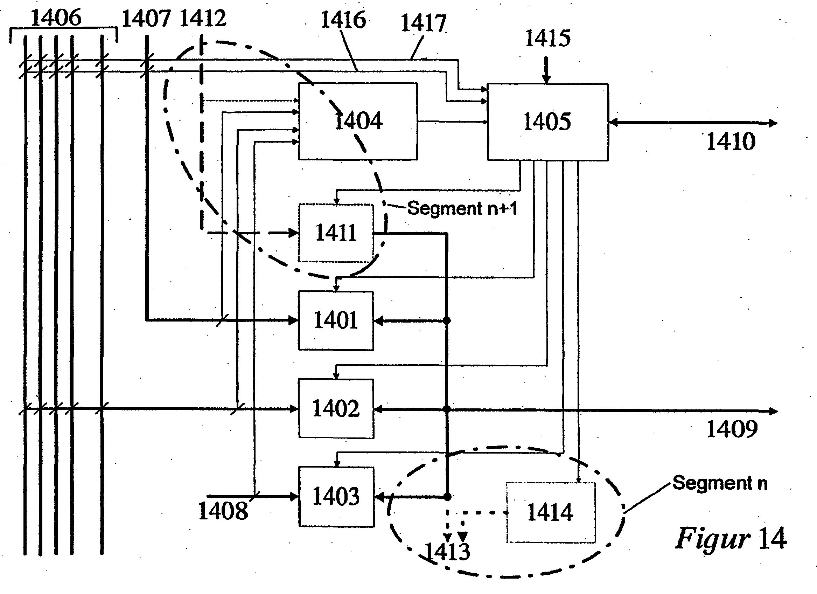

Figur 14 zeigt die Bus-IO Einheit. Sie ist mit dem internen Bussystem (1406), dem Test-Bussystem (1408) sowie dem Ladelogikbus (1407) verbunden. Der Bus (1412) und der Bus (1413) dient zur Verbindung der n-ten Bus-IO mit der (n+1)-ten Bus IO. Das heißt der Bus (1413) ist nur bei jedem n-ten Segment und der Bus (1412) ist nur bei jedem (n+1)-ten Segment vorhanden. Dabei sendet die n-te Bus-IO Daten über den Bus (1413) und die (n+1)-te Bus-IO empfängt diese Daten durch den Bus (1412). Die Bussysteme (1406, 1407, 1412) werden über die Tore (1401, 1402, 1403, 1411) auf den Bus (1409) geschaltet, der die Bus-IO mit dem Adress-Generator verbindet. Der Arbiter (1404) wählt ein Bussystem (1406, 1407, 1412) zur Datenübertragung aus und gibt ein Steuersignal an die State-Machine (1405), die ihrerseits die Tore (1401, 1402, 1403, 1411) steuert. Außerdem sendet die State-Machine (1405) noch Steuersignale (1410) an den Adress-Generator und das Ram.
Es gibt zwei Möglichkeiten:
a) Segment n: Die State-Machine (1405) erhält vom Adress-Generator ein Konfigurationssignal (1415), das festgelegt ob eine indirekte Adressierung erfolgen soll. Nach einem Read- Trigger-Signal (1416) vom internen Bus (1406) oder dem Ladelogikbus (1407) schaltet die State Machine (1405) das zugehörige Tor (1401, 1402, 1403, 1411) frei und erzeugt die Steuersignale (1410). Die durch den ladbaren Auf/Ab-Zähler (1509) adressierte Speicherstelle wird ausgelesen. Die in der Ram Speicherstelle enthaltenen Daten, werden nicht zum Bus zurückgeschickt, sondern durch den Bus (1413) zum (n+1)-ten Segment übertragen und dienen dort als Base-Adresse zur Adressierung des Ram. Die State-Machine (1405) gibt ein Acknowledge Signal zur Synchronisation nach Erhalt der Daten vom Ram an die State Machine (1414), die den Ablauf bei der indirekten-Adressierung steuert. Diese State Machine (1414) wird im folgenden Ind-State-Machine genannt. Sie erzeugt alle benötigten Kontrollsignale und schickt diese zum nachfolgenden Segment (1413).
b) Segment (n+1): Durch den Bus (1412) empfängt das (n+1)-te Segment, die vom n-ten Segment übertragenen Daten. Der Arbiter (1404) bekommt ein Write Signal und schickt seinerseits eine Anforderung an die State-Machine, die das Tor (1411) freischaltet. Das Tor (1411) fügt den Daten von 1412 die interne Adresse des Base-Adressen Eintrags zu, damit der Decoder (1502) die Base-Adressen-Latches freischaltet.

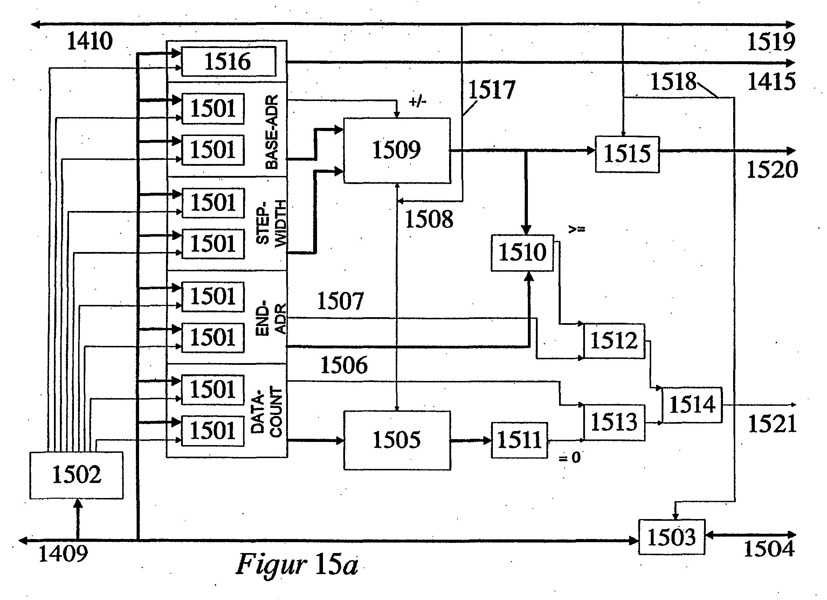

Figur 15a zeigt den Adress-Generator. Über den Bus (1409) werden Daten und Adressinformationen von der Dus-IO in den Adress-Generator übertragen. Der Bus (1410) überträgt die Kontrollsignale CLK (1517, 1508) und das Output-Enable-Signal (1518), sowie die Steuersignale zum Ram (1519). Das Output-Enable-Signal (1518) schaltet die Tore (1503, 1515) frei. Tor (1503) schaltet die Daten von Bus (1409) auf den Datenbus (1904) zum Ram. Das Tor (1515) schaltet die erzeugten Adressen auf den zum Ram führenden Adress-Bus (1520).
Die Adressen werden auf folgende Art generiert: Im Adressgenerator gibt es vier Einträge, die zur Adressgenerierung dienen. Jeder Eintrag wird in zwei Latches (1501) gespeichert, wobei ein Latch die höherwertige Adresse und das andere Latch die niederwertige Adresse speichert. Der Base-Adressen Eintrag enthält die Startadresse eines Speicherzugriffs. Der Step-Width Eintrag wird im ladbaren Auf/Ab-Zähler (1509) zur Base-Adresse hinzuaddiert oder abgezogen. Die Funktion (Auf/Ab) des ladbaren Auf/Ab-Zählers (1509) wird in einem Bit der Base-Adresse kodiert und zum ladbaren Auf/Ab-Zähler (1509) übertragen.
Im End-Adressen Eintrag wird die Endadresse gespeichert und in einem Bit kodiert, ob die Adressgenerierung beim Erreichen der Endadresse abbricht oder der End-Adressen Eintrag ignoriert wird. Soll bis zu einer Endadresse gezählt werden, wird der Wert des End-Adress-Eintrages mit dem Ausgangswert des ladbaren Auf/Ab-Zählers verglichen. Dies geschieht im Komparator (1510), der sobald die Endadresse erreicht oder überschritten ist, einen Highpegel erzeugt. Bei aktivem Enable-End-Address Signal (1507) gibt das UND-Gatter (1512) diesen Highpegel zum ODER-Gatter (1514), das dann ein Trigger-Signal (1521) zum Ladelogikbus weitergibt.
Im Data-Count Eintrag steht die Anzahl der Datentransfers und somit der zu berechnenden Adressen. Auch hier wird über ein Bit im Data-Count Eintrag festgelegt, ob diese Funktion aktiviert ist und das Enable-Data-Counter Signal (1506) zum UND-Gatter (1513) geleitet wird oder der Data-Count Eintrag ignoriert wird. Der Zähler (1505) übernimmt den Wert des Data-Count Eintrags und dekrementiert ihn bei jedem Clockimpuls um Eins. Der Vergleicher (1511) vergleicht den Wert des Zählers (1505) auf Null und gibt ein Signal zum UND-Gatter (1513). Ist das Enable-Data-Counter Signal (1506) aktiv, wird das Signal des Komparators (1511) zum ODER-Gatter (1514) geleitet und als Tigger Signal (1521) zum Ladelogikbus geleitet.
Bestandteil des Busses (1409) sind Steuersignale und Adressen für den Decoder (1502), der eines der Latche (1501) entsprechend der Adresse auswählt. Über den Decoder (1502) läßt sich auch das Konfigurationsregister (1516) ansteuern, das festlegt ob das Segment für indirekte Adressierung verwendet wird. Die Daten des Konfigurationsregisters werden über die Verbindung (1415) zur Bus IO des Segments übertragen.

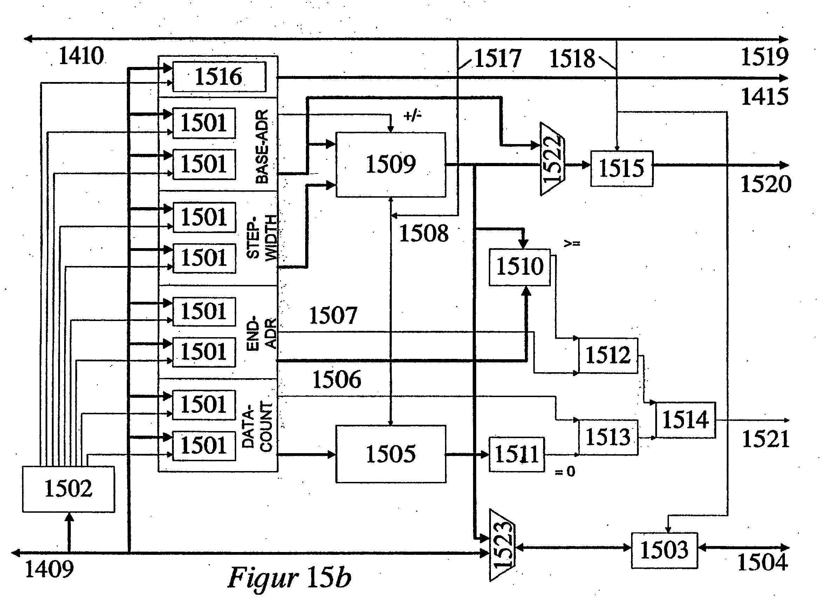

Figur 15b zeigt eine Abwandlung des Adress-Generators aus Figur15a, der am Anfang eines Datenblocks im Speicher, die Endadresse des Datenblocks ablegt. Der Vorteil dieser Ausführung besteht darin, daß bei variabler Größe des Datenblocks das Ende für spätere Zugriffe exakt definiert ist. Der Aufbau entspricht grundsätzlich dem Aufbau des Adress-Generators aus Figur 15a, jedoch mit der Erweiterung um zwei Multiplexer (1522, 1523) und einem zusätzlichen Eintrag im Konfigurationsregister (1523). Dieser Eintrag wird im folgenden Calculate-End-Adress genannt und legt fest, ob die Endadresse des Datenblocks als erster Eintrag des Datenblocks an der durch den Base_Adressen Eintrag definierten Stelle abgelegt wird. Die Multiplexer werden von der State-Machine (1405) angesteuert. Der Multiplexer (1522) dient dazu die Base-Adresse oder den Ausgang des Zählers (1509) auf das Tor (1515) zu schalten. Der Multiplexer (1523) schaltet entweder die vom Bus (1404) kommenden Daten oder den Ausgang des Zählers (1509) auf das Tor (1503).

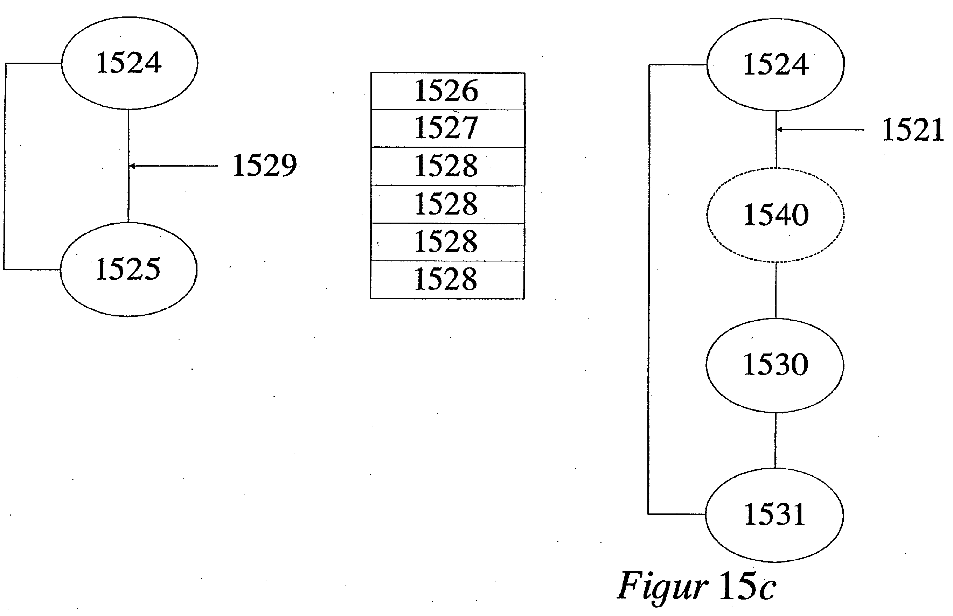

Figur 15c zeigt den Ablauf in der State-Machine und das Pattern des Speicherzugriffs durch den in Figur 15b dargestellten Adress-Generator. Die State-Machine (1405) befindet sich zunächst im IDLE Zustand (1524). Ist der Eintrag Calculate-End-Adress im Konfigurationregister (1523) gesetzt, geht die State-Machine (1405) nach dem Schreiben der Step-Width (1529) in den Zustand (1525) über. Dort wird die Adresse für den Zugriff auf das Ram aus dem Base-Adressen Eintrag in den ladbaren Auf/Ab-Zähler geschrieben und die Step-Width - je nach Zähler-Mode (Auf/Ab) - addiert oder subtrahiert. Der Ram-Zugriff wird durchgeführt und die State-Machine geht wieder in den IDLE (1524) Zustand über. Die folgenden Datentransfers erfolgen wie durch die Base-Adressen und Step-Width Einträge festgelegt. Damit sieht das Pattern im Speicher folgendermaßen aus. Die Base-Adresse (1526) wurde nicht beschrieben. Der erste Eintrag (1527) steht an der Position, die durch Base-Adresse plus (minus) Step-Width festgelegt wird. Die nächsten Einträge (1528) folgen im Step-Width Abstand aufeinander.
Ist das Transferende erreicht, wird ein Trigger-Signal generiert (1521). Aufgrund des Trigger-Signals (1521) oder eines externen Trigger-Signals (1417) geht die State-Machine (1405) vom IDLE-Zustand (1524) in den Zustand (1530) über. Dort werden die Multiplexer (1522, 1523) umgeschaltet, so daß die Base-Adresse am Eingang von Tor (1515) anliegt und die Adresse nach dem Ende des Datenblocks an Tor (1503) anliegt. Danach geht die State-Machine (1405) in den Zustand (1531) und schreibt die Adresse nach dem Ende des Datenblocks an der Position der Base-Adresse ins Ram. Das Pattern im Speicher sieht dann folgendermaßen aus. Der Eintrag der Base-Adresse (1526) gibt die Adresse nach dem Ende des Datenblocks an. Der ersten Eintrag im Datenblock liegt an Adresse (1527), danach folgen die restlichen Einträge.
Eine weitere Ausgestaltungsmöglichkeit der State-Machine ist, daß aufgrund eines der Trigger-Signale (1521 oder 1417) die State-Machine zunächst den Zählerstand in 1509 so korrigiert, daß 1509 auf das letzte Datenwort des Datenblocks zeigt. Dies wird technisch realisiert, indem die inverse Operation zu der voreingestellten in 1509 durchgeführt wird, d.h. addiert 1509 gemäß Voreinstellung die Step-Width, wird Step-Width nun subtrahiert; subtrahiert 1509 gemäß Voreinstellung, wird addiert. Um die Korrektur durchzuführen ist in der nachfolgend in Figur 15c beschriebenen State-Machine ein zusätzlicher Zustand (1640) notwendiq, um 1509 entsprechend anzusteuern.

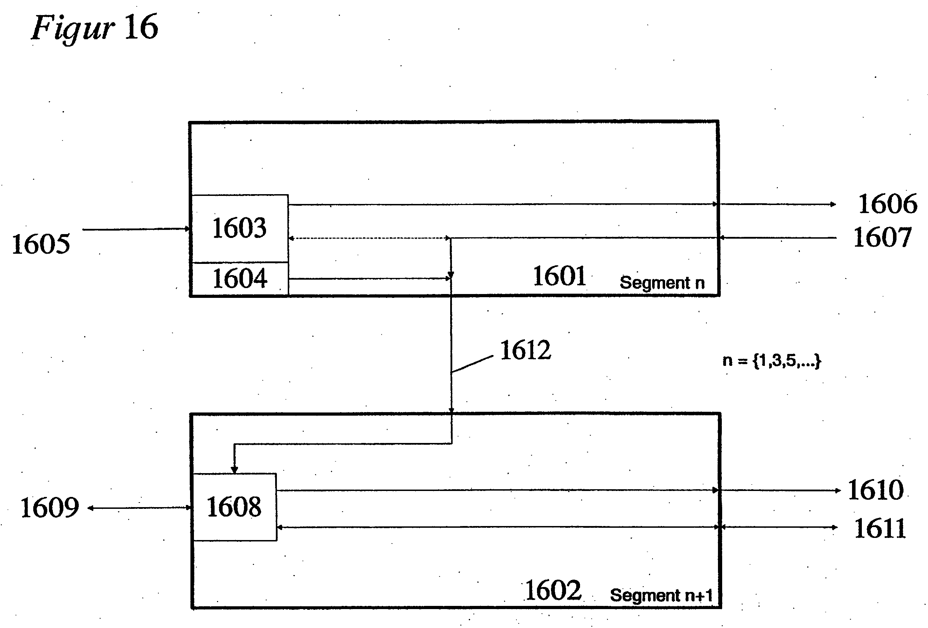

Figur 16 zeigt das Zusammenspiel mehrerer Segmente bei der indirekten Adressierung. Das Segment n (1601) empfängt über den Bus (1605) (der Ladelogikbus (1407) oder der interne Bus (1406)) ein Read Signal. Die Bus-IO (1603) schaltet das zugehörige Tor frei und erzeugt die benötigten Kontrollsignale. Die durch 1509 festgelegte Speicherstelle wird adressiert. Die vom Ram kommenden Daten (1607) werden zu Segment (n+1) (1602) geschickt. Die Ind-State-Machine (1604) erzeugt die benötigten Kontrollsignale und schickt sie ebenfalls zu Segment (n+1) (1602). In Segment (n+1) (1602) passieren die Signale das in Figur 14 beschriebene Gate (1411) der Bus-IO (1608). Dort wird eine Adresse für den in Figur 15 beschriebenen Decoder (1502) hinzugefügt, so daß der Base-Adressen Eintrag des Adress-Generators (1608) von Segment (n+1) (1602) angesprochen wird. Die von Segment n (1601) kommenden Daten, dienen damit als Base-Adresse in Segment (n+1) (1602), das heißt ein Read/Write Zugriff über den Bus (1609) (der Ladelogikbus (1407) oder der interne Bus (1406)) kann diese Base-Adresse für einen Zugriff auf das Ram verwenden. Der Bus (1610) dient zur Übertragung der Adressen zum Ram und der Bus (1612) überträgt die Daten von und zum Ram, abhängig ob ein Read oder Write Zugriff erfolgt.

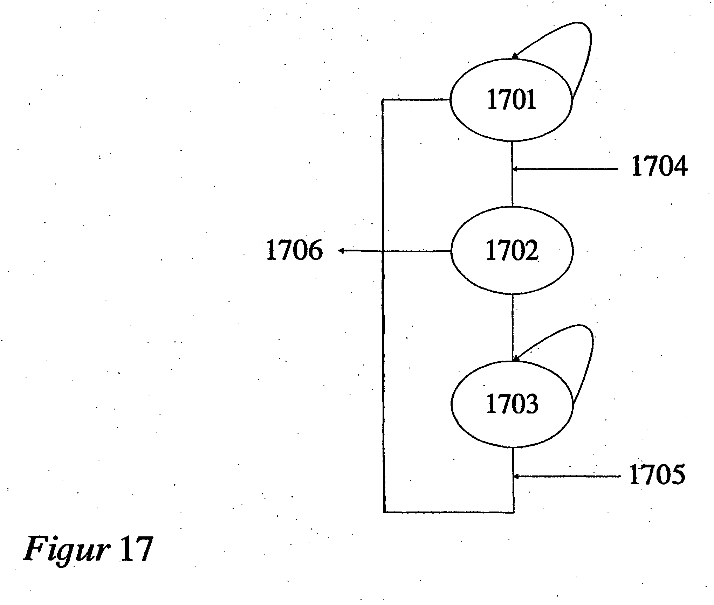

Figur 17 zeigt die Ind-State-Machine. Der Grundzustand ist der IDLE Zustand (1701). In diesem Zustand verbleibt sie bis zum Eintreffen des Acknowledge Signals der State-Machine (1405) aus Figur 14. Danach geht die Ind-State-Machine in den Zustand Write (1702) über und erzeugt ein Write Enable Signal, das mit den Daten zu Segment (n+1) geschickt wird. Es dient dort dazu, den Decoder, der die verschiedenen Einträge auswählt, zu aktivieren. Anschließend erfolgt der Übergang zum Zustand Wait_for_Ack. Nach dem Acknowledge Signal des Segments (n+1) geht die Ind-Statemachine wieder in den IDLE (1701) Zustand.

Beschrieben wird somit ein Bussystem, hergestellt durch Bündelung mehrerer einzelner Leitungen oder Busse oder Teilbusse (vgl. Fig. 4/5) innerhalb eines Bausteines der Gattung DFP, FPGA, DPGA, sowie allen Bausteinen mit zwei- oder mehrdimensionaler programmierbarer Zellstruktur (vgl. Fig. 1/2/3), über welches die Bausteine zu mehreren zusammengefaßt werden können und/oder Speicher und/oder Peripherie anschließbar ist (vgl. Fig. 10), wobei vorgesehen sein kann, daß eine oder mehrere Schnittstellen (Fig. 6/7) die Zusammenfassung der Leitungen übernehmen und das Bussystem erzeugen, und/oder daß eine oder mehrere Zustandsmaschine(n) (0703/0603) die Schnittstellen (vgl. Fig. 6/7) steuert/steuern und/oder daß die Zustandsmaschine auch den externen Bus steuert, und/oder daß ein Adressgenerator existiert (0610/0710), der die Adressen für die über den Bus zu kontaktierenden Bausteine generiert, und/oder daß die Schnittstellen ein internes Bussystem oder mehrere interne Bussysteme, das/die aus mehreren Leitungen zusammengefaßt sein kann/können (vgl. Fig. 4/5), zum Schreiben und Lesen verwendet (vgl. Fig 9a, I-BUS), und/oder daß die Schnittstellen ein internes Bussystem oder mehrere interne Bussysteme, das/die aus mehreren Leitungen zusammengefaßt sein kann/können (vgl. Fig. 4/5), entweder zum Schreiben oder Lesen verwendet (vgl. Fig. 9b, II-BUS, IO-BUS), und/oder daß die Schnittstellen ein internes Bussystem oder mehrere interne Bussysteme, das/die aus mehreren Leitungen zusammengefaßt sein kann/können (vgl. Fig. 4/5), gemischt betreiben, und/oder daß ein Register zur Verwaltung und Steuerung des Bussystems existiert (EB-REG, 0702, 0602), und/oder daß die Bussteuerung durch einen Baustein (E-BUS-MASTER) erfolgt, der auf eine Vielzahl von untergeordneten Bausteinen (E-BUS-SLAVE) zugreift, und/oder daß die Bussteuerung dynamisch von einem Baustein (E-BUS-MASTER) an einen anderen übergeben wird (MASTER-Eintrag im EB-REG), und/oder daß ein untergeordneter Baustein (E-BUS-SLAVE) den Erhalt der Buskontrolle fordern kann (REQ-MASTER-Eintrag im EB-REG), und/oder daß ein Register existiert, das anzeigt, ob Daten in den Schnittstellen gespeichert sind (SET-REG, 0612, 0712), und/oder daß die Schnittstellen entweder direkt auf dem Baustein implementiert sind, oder durch die Konfiguration von Logikzellen, das sind Zellen in DFP-, FPGA-, DPGA- oder ähnlichen Bausteinen, die einfache logische oder arithmetische Aufgaben gemäß ihrer Konfiguration erfüllen, entstehen, und/oder daß die Schnitttstellen von einer Ladelogik und/oder dem Baustein selbst (vgl. Fig. 8/11) konfiguriert werden können, und/oder daß die Ladelogik partiell auf dem Baustein integriert ist, und/oder daß Standardbussysteme eingesetzt werden können (vgl. Fig. 12), und/oder daß der Baustein weitere gewöhnliche Anschlüsse nach bei DFPs, FPGAs, DPGAs oder ähnlicher üblicher Art besitzt (vgl. Fig. 12, 1201, 1204).

### Begriffsdefinition

- ADR-GATE: Tor, das die Adressen auf den E-BUS aufschaltet, sofern der Baustein E-BUS-MASTER ist.
- DFP: Datenflußprozessor nach Patent/Offenlegung DE 44 16 881
- DPGA: Dynamisch konfigurierbare FPGAs. Stand der Technik
- D-FlipFlop: Speicherelement, welches ein Signal bei der steigenden Flanke eines Taktes speichert.
- EB-REG: Register, das sie Statussignale zwischen I-BUS und E-BUS speichert.
- E-BUS: Externes Bussystem außerhalb eines Bausteines.
- E-BUS-MASTER: Baustein, der den E-BUS steuert. Aktiv.
- E-BUS-SLAVE: Baustein, der vom E-BUS-MASTER angesprochen wird. Passiv.
- E-GATE: Tor, das von der bausteininternen Zustandsmaschine oder vom E-BUS-MASTER gesteuert wird und Daten auf den E-BUS aufschaltet.
- E-GATE-REG: Register in das die Daten eingestragen werden, die über das E-GATE auf den E-BUS übertragen werden.
- E-READ: Flag im EB-REG, das anzeigt, daß die OUTPUT-CELLs komplett auf den E-BUS übertragen wurden.
- E-WRITE: Flag im EB-REG, das anzeigt, daß der E-BUS komplett in die INPUT-CELLs übertragen wurde.
- Flag: (Fahne). Statusbit in einem Register, das einen Zustand anzeigt.
- FPGA: Programmierbarer Logikbaustein. Stand der Technik.
- Handshake: Signalprotokoll, bei dem ein Signal A einen Zustand anzeigt und ein anderes Signal B bestätigt, daß es Signal A akzeptiert und darauf reagiert (hat).
- INPUT-CELL: Baugruppe, die Daten vom E-BUS auf einen I-BUS überträgt.
- I-BUSn: (auch I-BUS) Bausteininternes Bussystem, das auch aus Bündeln von einzelnen Leitungen bestehen kann. n gibt die Nummer des Busses an.
- II-BUSn: (auch II-BUS) Bausteininternes Bussystem, das auch aus Bündeln von einzelnen Leitungen bestehen kann. Der Bus wird von einer INPUT-CELL getrieben und geht auf logische Eingänge. n gibt die Nummer des Busses an.
- IO-BUSn: (auch IO-BUS) Bausteininternes Bussystem, das auch aus Bündeln von einzelnen Leitungen bestehen kann. Der Bus wird von logischen Ausgängen getrieben und geht an eine OUTPUT-CELL. n gibt die Nummer des Busses an.
- I-GATE: Tor, das Daten auf den I-BUS aufschaltet.
- I-GATE-REG: Register, das von der bausteininternen Zustandsmaschine oder vom E-BUS-MASTER gesteuert wird und in das die Daten eingestragen werden, die über das I-GATE auf den I-BUS übertragen werden.
- I-READ: Flag im EB-REG, das anzeigt, daß die INPUT-CELLs komplett auf den I-BUS übertragen wurden.
- I-WRITE: Flag im EB-REG, das anzeigt, daß der I-BUS komplett in die OUTPUT-CELLs übertragen wurde.
- Kantenzelle: Zelle am Rand eines Zellarrays, oftmals mit direktem Kontakt zu den Anschlüssen eines Bausteines.
- Konfigurieren: Einstellen der Funktion und Vernetzung einer logischen Einheit, einer (FPGA)-Zelle (Logikzelle) oder einer PAE (vgl. umkonfigurieren).
- Ladelogik: Einheit zum Konfigurieren und Umkonfigurieren einer PAE oder Logikzelle. Ausgestaltet durch einen speziell an seine Aufgabe angepaßten Mikrokontroller.
- Latch: Speicherelement, das ein Signal für gewöhnlich während des H-Pegels transparent weiterleitet und während des L-Pegels speichert. In PAEs werden teilweise Latches gebraucht, bei denen die Funktion der Pegel genau umgekehrt ist. Hierbei wird vor den Takt eines üblichen Latch ein Inverter geschaltet.
- Logikzellen: Bei DFPs, FPGAs, DPGAs verwendete konfigurierbare Zellen, die einfache logische oder arithmetische Aufgaben gemäß ihrer Konfiguration erfüllen.
- MASTER: Flag im EB-REG, das anzeigt, daß der Baustein E-BUS-MASTER ist.
- MODE-PLUREG: Register in dem die Ladelogik die Konfiguration einer INPUT-/OUTPUT-CELL einstellt.
- OUTPUT-CELL: Baugruppe, die Daten von einem I-BUS auf den E-BUS überträgt.
- PAE: Processing Array Element: EALU mit O-REG, R-REG, R20\-MUX, F-PLUREG, M-PLUREG, BM-, SM-, Sync-, StateBack- und Power-UNIT.
- PLU: Einheit zum Konfigurieren und Umkonfigurieren einer PAE oder Logikzelle. Ausgestaltet durch einen speziell an seine Aufgabe angepaßten Mikrokontroller.
- REQ-MASTER: Flag im EB-REG, das anzeigt, daß der Baustein E-BUS-MASTER werden möchte.
- RS-FlipFlop: Reset-/Set-FlipFlop. Speicherelement, das durch 2 Signale umgeschaltet werden kann.
- SET-REG: Register das anzeigt, daß Daten in ein I-GATE-REG oder E-GATE-REG geschrieben und noch nicht gelesen wurden.
- STATE-GATE: Tor, das den Ausgang des SET-REG auf den E-BUS schaltet.
- Tor: Schalter, der ein Signal weiterleitet oder sperrt. Einfacher Vergleich: Relais
- Umkonfigurieren: Neues Konfigurieren von einer beliebigen Menge von PAEs oder Logikzellen während eine beliebige Restmenge von PAEs oder Logikzellen ihre eigenen Funktionen fortsetzen (vgl. konfigurieren).
- Zustandsmaschine: Logik, die diversen Zuständen annehmen kann. Die Übergänge zwischen den Zuständen sind von verschiedenen Eingangsparametern abhängig. Diese

## Patentansprüche

1. Verwaltungsmittel zur Verwaltung der Zugriffe auf externe Anschlüsse eines Bausteines mit mehrdimensional angeordneter, programmierbarer Zellstruktur, wobei zwischen zumindest einem der internen Busse und einem der externen Busse ein Cache-Mittel vorgesehen ist, um Daten, die über die externen Busse angefordert werden sollen, cachen zu können und nur für solche Daten eine Aufschaltung auf die externen Busse vorzusehen, die nicht gecached oder cachebar sind.

2. Anordnung mit
einem Prozessor,
einem Speicher und
einem Cache-Speicherverwaltungsmittel,
**dadurch gekennzeichnet, daß**
der Prozessor mit
einer Vielzahl bezüglich Funktion und
Vernetzung konfigurierbarer und
über ein globales internes Bussystem verbindbarer Zellen gebildet ist und
das globale interne, die Zellen konfigurierbar vernetzende Bussystem zum Speicherverwaltungsmittel geführt ist.

3. Anordnung nach dem vorhergehenden Anspruch,
**dadurch gekennzeichnet, daß**
der Prozessor als Coprozessor gebildet ist.

4. Einheit zur Verwaltung externer Anschlüsse
eines Bausteines mit
mehrdimensional angeordneter, programmierbarer Zellenstruktur, wobei im Baustein
ein internes Bussystem für die Zellstruktur und
Anschlüsse für externe Bausteine vorgesehen sind und die Einheit einem internen Bussystem und/oder Leitungsbündel zugeordnet ist, mit
einem Steuermittel zur synchronisierenden Ansteuerung externer Bausteine und/oder Busse in der Einheit und
einem Adressgeneriermittel zur Generierung der Adressen externer Bausteine.

5. Einheit zur Verwaltung externer Anschlüsse
eines Bausteines mit
mehrdimensional angeordneter, programmierbarer Zellenstruktur,
**dadurch gekennzeichnet, daß**
eine Vielzahl von internen Bussen und
ein Multiplexermittel zur Aufschaltung eines wählbaren der Vielzahl interner Busse auf die externen Anschlüsse
und/oder
eine Vielzahl externer Anschlüsse und
ein Multiplexermittel zur Aufschaltung eines wählbaren der Vielzahl externer Anschlüsse auf einen internen Bus vorgesehen ist.

6. Anordnung mit
einem Prozessor,
einem Speicher und/oder Peripherie und
einem Adressgenerierungsmittel zur Speicher- und/oder Peripherieadressierung,
**dadurch gekennzeichnet, daß**
der Prozessor mit
einer Vielzahl bezüglich Funktion und Vernetzung konfigurierbarer und über ein globales internes Bussystem verbindbarer Zellen gebildet ist und
das globale interne, die Zellen konfigurierbar vernetzende Bussystem zum Adressierungsmittel geführt ist.

7. Einheit nach dem vorhergehenden Anspruch, **dadurch gekennzeichnet, daß**
der Prozessor als Coprozessor gebildet ist.

8. Einheit zur Kommunikation zwischen
einer externen Einheit und
einem Prozessor mit einer Anordnung
über ein globales Bussystem untereinander konfigurierbar verbindbaren Logikzellen, die arithmetische Aufgaben gemäß ihrer Konfiguration erfüllen können, mit einem Steuermittel zur synschronisierenden Ansteuerung externer Bausteine und Busse in der Einheit und
einem Adressgeneriermittel zur Generierung der Adressen externer Bausteine und Synchronisation mit der internen Zellstruktur.

9. Einheit nach Anspruch 8, **dadurch gekennzeichnet, daß** zumindest für einen Teil der ein- und/oder ausgehenden Daten Halteglieder (611, 715, 707) vorgesehen sind.

10. Einheit nach einem der vorhergehenden Ansprüche, worin ein Anschluss zur Bausteinkonfigurierung durch die Zellstruktur vorgesehen ist.
